Europäisches Patentamt

(19) European Patent Office

Office européen des brevets

(11) Numéro de publication : **0 113 273**
**B1**

# (12) FASCICULE DE BREVET EUROPÉEN

(45) Date de publication du fascicule du brevet :
**11.02.87**

(51) Int. Cl.⁴ : **H 01 L 23/56**

(21) Numéro de dépôt : **83402445.7**

(22) Date de dépôt : **16.12.83**

(54) **Boîtier d'encapsulation pour semiconducteur de puissance, à isolement entrée-sortie amélioré.**

(30) Priorité : **28.12.82 FR 8221860**

(43) Date de publication de la demande :
**11.07.84 Bulletin 84/28**

(45) Mention de la délivrance du brevet :
**11.02.87 Bulletin 87/07**

(84) Etats contractants désignés :
**DE GB NL**

(56) Documents cités :
**EP-A- 0 065 443**
**US-A- 4 259 684**

(73) Titulaire : **THOMSON-CSF**
**173, Boulevard Haussmann**
**F-75379 Paris Cedex 08 (FR)**

(72) Inventeur : **Bessonneau, Guy**
**THOMSON-CSF SCPI 173, bld Hausmann**
**F-75379 Paris Cedex 08 (FR)**
Inventeur : **Carnez, Bernard**
**THOMSON-CSF SCPI 173, bld Hausmann**
**F-75379 Paris Cedex 08 (FR)**
Inventeur : **Derewonko, Henry**
**THOMSON-CSF SCPI 173, bld Hausmann**
**F-75379 Paris Cedex 08 (FR)**
Inventeur : **Lepage, Joel**
**THOMSON-CSF SCPI 173, bld Hausmann**
**F-75379 Paris Cedex 08 (FR)**

(74) Mandataire : **Taboureau, James et al**
**THOMSON-CSF SCPI 19, avenue de Messine**
**F-75008 Paris (FR)**

EP 0 113 273 B1

## Description

La présente invention concerne un boîtier d'encapsulation pour semiconducteur fonctionnant dans une gamme de fréquence comprise entre 2 et 20 GHz. Le boîtier selon l'invention est adapté pour améliorer l'isolement entre ses connexions d'entrée et de sortie, au moyen d'une métallisation recouvrant tout le boîtier, sauf autour des connexions d'entrée-sortie, cette métallisation étant à la masse.

Les dispositifs semiconducteurs concernés par l'invention sont les semiconducteurs hyperfréquences fonctionnant entre 2 et 20 GHz. Les dispositifs semiconducteurs fonctionnant à des fréquences inférieures peuvent également être encapsulés dans de tels boîtiers, mais les phénomènes de dispersion d'énergie ne sont pas les mêmes aux basses fréquences. Les pastilles de composants hyperfréquences sont montrées dans des boîtiers adaptés aux conditions de fréquences, et qui comportent en général une embase métallique, pour la fixation du boîtier et l'évacuation des calories dégagées au cours du fonctionnement, et un cadre isolant traversé par deux rubans métalliques formant deux connexions externes, la troisième connexion étant formée par l'embase. Les semiconducteurs montés dans de tels boîtiers fonctionnent très bien tant que le boîtier n'a pas de couvercle. Mais un couvercle est nécessaire pour protéger la pastille de semiconducteur et ses liaisons, fragiles, par fils d'or avec les connexions externes.

Fermer le boîtier au moyen d'un couvercle isolant entraîne la nécessité d'une soudure céramique sur céramique, car il est exclu que le boîtier et son couvercle soient en un isolant polymère. Le ruban de soudure de fermeture créé, par couplages capacitifs parasites au niveau des deux rubans de connexion, un couplage entrée-sortie qui détériore l'isolement entrée-sortie du semiconducteur, en le shuntant par un réseau parasite.

On connaît de nombreux types de boîtiers céramiques, car ce sont les mieux adaptés à l'électronique hyperfréquence, et aux spécificités des matériels militaires. Généralement, avec des boîtiers céramiques, les problèmes portent sur la réalisation des connexions d'entrées-sorties, plus délicates à réaliser qu'avec des boîtiers plastiques ou métalliques, ces derniers comportant des connexions d'accès par perles de verre. En outre, les boîtiers céramiques ne comportent pas de blindage du composant encapsulé.

Cependant, il est connu du document US-A-4 259 684 un boîtier céramique spécialement conçu pour les circuits intégrés hyperfréquence. Son embase est constituée par deux plaques de céramique soudées ensemble par une face métallisée, de sorte que cette métallisation forme une triplaque avec les microbandes déposées sur l'autre face, la céramique constituant le diélectrique de la triplaque. Le circuit encapsulé est protégé par un cadre et un couvercle, tous deux céramiques, et soudés ensemble par deux rubans de soudure en regard. Le cadre est lui-même fixé sur l'embase triplaque au moyen de cerre. Dans un but de blindage, les surfaces extérieures du couvercle et du cadre sont recouvertes d'une métallisation conductrice, électriquement isolée de chacune des microbandes d'accès au circuit intégré. Ce boîtier a l'avantage d'utiliser des techniques et des matériaux compatibles avec ceux utilisés dans la fabrication des lignes de transmission pour circuits hyperfréquences.

Selon l'invention, le boîtier, en matériaux isolants, est métallisé sur toute sa surface par une métallisation bonne conductrice de l'électricité, réunie au socle métallique et à la masse électrique du circuit, avec seulement des réserves de métallisation autour des passages de connexions extérieures, afin de ne pas les court-circuiter entre elles. La fraction d'énergie prélevée sur une connexion extérieure par l'intermédiaire d'un condensateur parasite est réfléchie par la masse électrique ramenée en surface du boîtier.

De façon plus précise, l'invention concerne un boîtier d'encapsulation pour semiconducteur de puissance fonctionnant dans une gamme de fréquence de 2 à 20 GHz, comprenant une embase métallique, un cadre en matériau isolant à travers lequel passent au moins deux connexions externes d'accès au semiconducteur encapsulé, dites d'entrée et de sortie, et un couvercle en matériau isolant, fixé sur le cadre par soudure au moyen d'une métallisation déposée sur la face libre du cadre et d'une métallisation déposée sur la face du couvercle en regard du cadre, la face extérieure du cadre et du couvercle étant de plus recouverte par une métallisation conductrice, ménageant des réserves autour des connexions d'entrées-sorties, ce boîtier étant caractérisé en ce que l'isolement entre les connexions d'entrée et de sortie est amélioré par la mise en contact électrique de la métallisation conductrice extérieure, elle-même en contact avec les métallisations de soudure, avec l'embase métallique qui est à la masse électrique du circuit comprenant le semiconducteur encapsulé dans ce boîtier.

L'invention sera mieux comprise par la description qui suit d'un exemple de réalisation, celle-ci s'appuyant sur les figures jointes en annexe et qui représentent :

figure 1   vue de trois quarts d'un boîtier hyperfréquences, ouvert, selon l'art connu,

figure 2   schéma électrique équivalent du boîtier de la figure précédente,

figure 3   schéma électrique équivalent d'un boîtier selon l'art connu perfectionné,

figure 4   vue de trois quarts d'un boîtier selon l'invention,

figures 5 et 6   schémas électriques équivalents du boîtier selon l'invention,

figure 7   courbes comparatives d'isolement en fonction de la fréquence de plusieurs boîtiers, connus et selon l'invention.

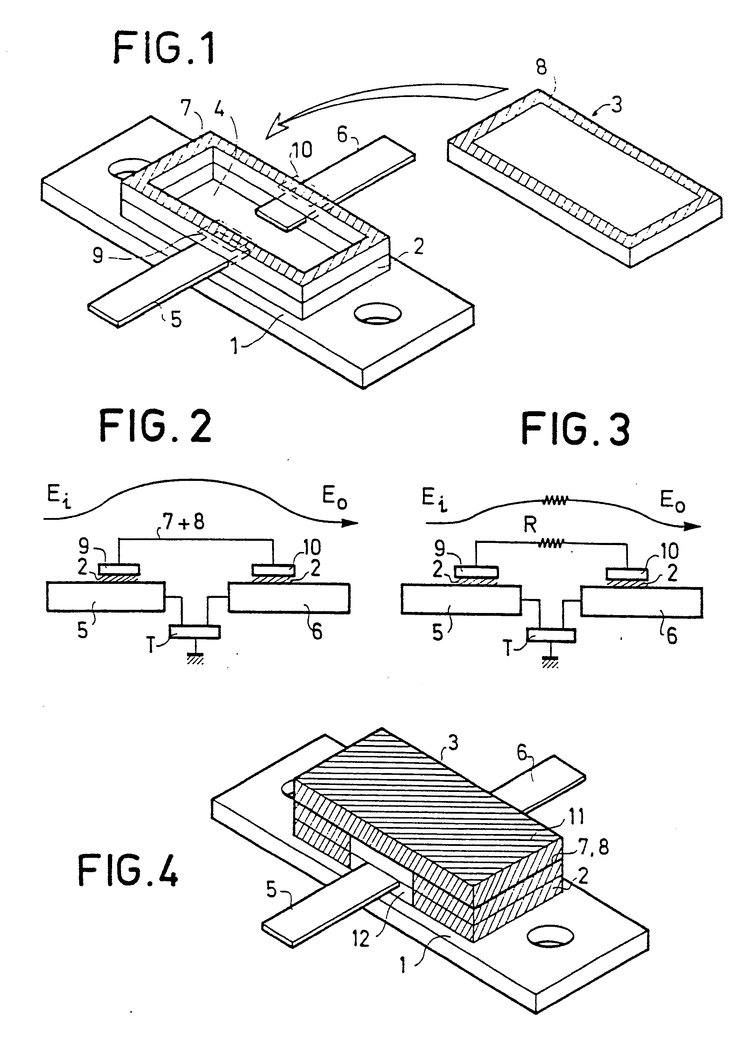

La figure 1 représente une vue de trois quarts dans l'espace d'un boîtier de puissance pour semiconducteur travaillant à de très hautes fréquences, dont le couvercle est ôté et retourné de façon à mieux montrer la structure du boîtier. Pour un tel boîtier de puissance, représenté ici dans une forme rectangulaire sans que cela soit limitatif puisque d'autres formes rondes ou carrées existent également, les pièces principales sont :

— une embase 1 généralement métallique, en cuivre ou laiton, dorée en surface,

— un cadre isolant 2 en céramique, alumine ou oxyde de béryllium, formé de deux parties superposées,

— un couvercle 3, également en céramique, alumine ou oxyde de béryllium.

L'ensemble ainsi formé, lorsqu'il est fermé, constitue une enceinte étanche 4 à l'intérieur de laquelle est fixé un dispositif semiconducteur qui n'est pas représenté. Lorsque celui-ci est un semiconducteur du type transistor et qu'il comporte trois électrodes, l'un des contacts est pris par l'intermédiaire de son substrat sur l'embase métallique 1 et les deux autres contacts sont pris sur les connexions d'accès extérieures 5 et 6, qui traversent le cadre 2 dans son épaisseur, et qui en hyperfréquence sont des plaquettes ou des rubans métalliques. Ces deux connexions extérieures 5 et 6 seront par la suite du texte appelées connexions d'entrée et de sortie.

Pour refermer de façon étanche ce boîtier connu, le cadre 2 est métallisé sur sa surface libre extérieure par un ruban métallique 7, et le couvercle 3 est également métallisé par un ruban métallique 8 qui a même forme et mêmes dimensions que le ruban 7 du cadre 2. La fermeture du boîtier se fait par soudure, par apport d'une soudure tendre entre les deux rubans métalliques 7 et 8.

Lorsqu'un dispositif semiconducteur, fonctionnant à hautes fréquences, est encapsulé dans un tel boîtier, l'énergie rayonne et en particulier il se forme deux condensateurs parasites au niveau de la traversée du cadre 2 par les connexions d'entrée et de sortie 5 et 6. La fraction du ruban 5 qui traverse l'épaisseur du cadre 2, et la fraction 9 du ruban de métallisation 7, déposée sur le dessus du cadre, forment les deux armatures d'un condensateur parasite dont le diélectrique est le matériau isolant, céramique ou alumine, du cadre 2. De la même façon, un second condensateur parasite est formé entre la fraction de la connexion de sortie 6 qui traverse le cadre, la fraction 10 du ruban 7 et le matériau du cadre 2. Ces deux condensateurs parasites fonctionnent comme des condensateurs de couplage et sont reliés entre eux par une ligne qui n'est pas résistive constituée par l'ensemble de la métallisation 7 sur le cadre, la métallisation 8 sur le couvercle, et le ruban de soudure qui réunit ces deux métallisations.

On est donc en présence, dans le domaine des hautes fréquences d'une double possibilité de résonnance. D'une part, il peut y avoir une résonnance de cavité, mais les dimensions données au boîtier, compte tenu de la fréquence de travail du dispositif semiconducteur, écartent cette possibilité de résonnance de cavité. Par contre, la métallisation de jonction entre le boîtier et son couvercle peut donner lieu à une résonnance de ligne, agissant comme une unique boucle d'une self réunie aux connexions d'entrée et de sortie par deux condensateurs de couplage.

C'est ce que représente la figure 2 qui donne le schéma électrique équivalent d'un tel boîtier.

Les connexions d'entrée et de sortie 5 et 6 sont seules représentées et les deux condensateurs parasites sont formés par une fraction de la céramique du cadre 2 et par une fraction, 9 et 10, de la métallisation de fermeture du couvercle. Ces deux condensateurs parasites sont réunis entre eux par une ligne directe représentée par les métallisations 7 et 8, et cette ligne directe court-circuite le dispositif semiconducteur, désigné T. La puissance transmise depuis la connexion d'entrée 5 vers la connexion de sortie 6 est symbolisée par la ligne qui figure au-dessus du schéma électrique et pour une puissance $E_i$ sur la connexion d'entrée, une puissance $E_o$ non négligeable se retrouve sur la connexion de sortie : il n'y a donc pas un bon isolement entre les deux connexions d'entrée et de sortie.

La figure 3 représente le schéma électrique équivalent d'un boîtier selon l'art connu, perfectionné selon une demande de brevet N° 81 09 935 de la Demanderesse.

Le boîtier selon cette demande de brevet a la même configuration géométrique que le boîtier de la figure 1, ou que tout autre boîtier selon l'art connu. Cependant, la solution apportée au problème de détérioration de l'isolement entre les connexions d'entrée et de sortie consiste en une métallisation résistive d'une surface du couvercle céramique, métallisation qui englobe les tranches latérales de la plaquette de céramique qui constitue le couvercle, et qui est en contact électrique avec le dépôt ou la préforme de soudure tendre prévue pour souder le couvercle sur le boîtier. La liaison directe entre les condensateurs parasites est remplacée par une ligne à perte dont la résistance très élevée de la métallisation atténue très fortement le couplage entre les condensateurs parasites sur les connexions d'entrée et de sortie. Aux fréquences concernées, de 1 à 100 GHz environ, le mode de propagation des ondes électriques dans ou sur la céramique du couvercle et dans la couche résistive fait que le cordon de soudure ne constitue par un court-circuit à la métallisation résistive.

Ainsi, sur la figure 3, la ligne directe qui était représentée en figure 2 est remplacée par une résistance de valeur élevée, et l'énergie prélevée sur la connexion d'entrée 5 par le premier condensateur parasite est atténuée par passage à travers cette résistance élevée et une partie seulement de l'énergie $E_o$ est transmise sur la connexion de sortie 6. Ceci constitue un perfectionnement mais il demeure néanmoins une certaine perte d'énergie par l'intermédiaire d'un couplage RC entre l'entrée et la sortie. A titre d'exemple, à 14 GHz de fréquence de fonctionnement pour le dispositif semiconducteur encapsulé, l'isolement entre les connexions d'entrée et de sortie atteint — 15 db.

La figure 4 représente une vue de trois quarts du boîtier selon l'invention.

Ce boîtier a la même forme géométrique que le boîtier de la figure 1 ou que celui qui a été décrit dans la demande de brevet de la Demanderesse. Il pourrait d'ailleurs tout aussi bien être d'une autre forme telle que carrée ou circulaire. Il comporte une embase métallique 1, un cadre céramique 2 et un couvercle de fermeture 3. Deux connexions d'entrée et de sortie 5 et 6 traversent le cadre métallique dans son épaisseur. En vue d'améliorer l'isolation entrée-sortie du dispositif encapsulé, l'ensemble de la surface extérieure du boîtier, cadre 2 et couvercle 3, est métallisé par une métallisation conductrice, 11, à l'exception des passages 12 autour des deux connexions d'entrée-sortie 5 et 6, ces passages étant réservés pour éviter le contact entre le métal des connexions et le métal de la métallisation 11, ce qui causerait un court-circuit entrée-sortie. Cette métallisation est opérée d'une part sur le couvercle 3, d'autre part sur le boîtier sans son couvercle, c'est-à-dire qu'il est représenté en figure 1 : un cache permet de protéger lors de la métallisation la partie centrale du boîtier sur laquelle sera fixée la pastille de semiconducteur ainsi que les deux réserves faites autour des passages des deux connexions d'entrée et sortie. Par conséquent, en raison même du procédé de fabrication du boîtier, la métallisation qui se trouve déposée sur le cadre céramique 2 se trouve être en contact avec l'embase métallique 1 du boîtier, et lorsque le couvercle est soudé pour refermer le boîtier, c'est l'ensemble de l'embase 1, de la métallisation 11 sur le cadre 2, et de cette même métallisation 11 sur le couvercle 3 qui constitue la masse électrique du boîtier. Il est à noter que, étant donné que la métallisation du cadre a lieu sur un boîtier ouvert, la partie intérieure du cadre, c'est-à-dire celle qui est à l'intérieur de la cavité du boîtier, est également métallisée.

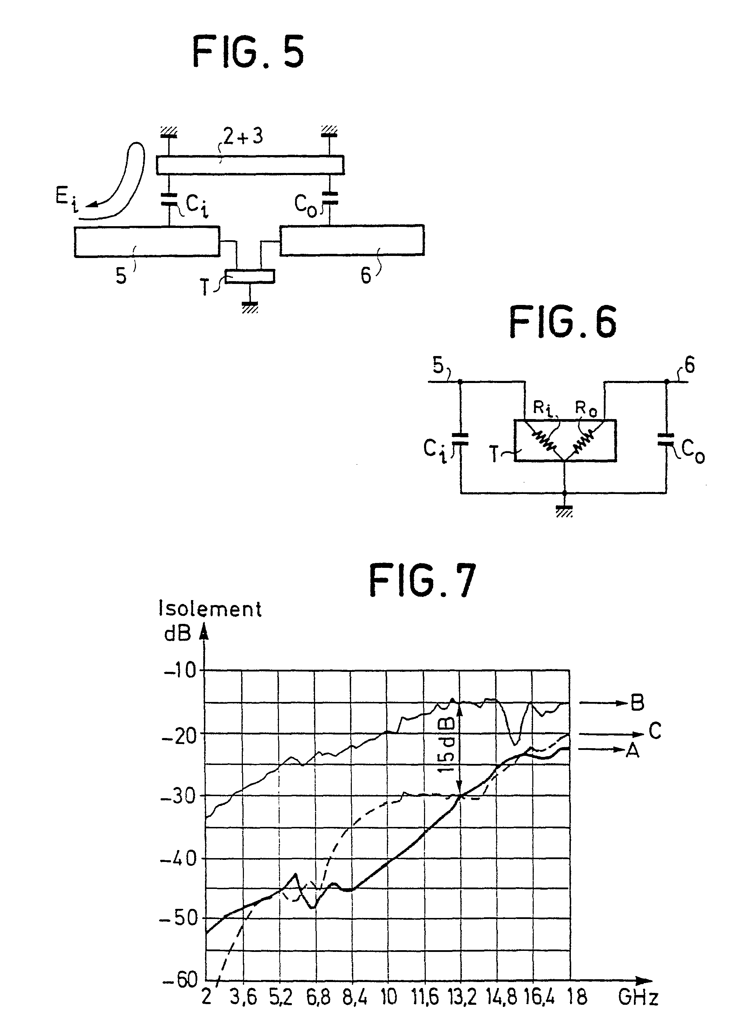

Dans ces conditions, les condensateurs parasites formés entre une fraction des rubans de connexion d'entrée et sortie 5 et 6, et la fraction correspondante du ruban de métallisation 7 sur la partie supérieure du cadre 2, existent toujours ; mais l'énergie $E_i$ prélevée sur la connexion d'entrée 5 dans ce type de boîtier par le condensateur parasite correspondant est réfléchie par la masse, puisqu'il est connu qu'en hyperfréquences une onde est réfléchie par un circuit ouvert ou par une masse. Une très faible partie de l'énergie incidente $E_i$ est transmise sur la connexion de sortie 6. C'est ce que représente la figure 5 qui est le schéma électrique équivalent du boîtier selon l'invention.

Par comparaison avec les figures 2 et 3, sur la figure 5 l'ensemble du cadre 2 et du couvercle 3, métallisé et soudé, constitue un tout qui est électriquement mis à la masse. Par conséquent, la différence par rapport à la figure 2 est que s'il existe bien une ligne directe non résistive entre les deux condensateurs d'entrée et de sortie, cette ligne directe est mise à la masse au plus près du point où est prélevée l'énergie incidente et au plus près du point où est délivrée l'énergie de sortie. Le schéma équivalent, donné en figure 6, montre que si $R_i$ est l'impédance d'entrée du dispositif semiconducteur T, l'onde incidente sur la connexion d'entrée 5 est transmise à travers un réseau RC formé par l'impédance $R_i$ du semiconducteur et la capacité d'entrée $C_i$ du boîtier ; de même l'impédance de sortie est for-mée par $R_o$ et $C_o$, $R_o$ étant l'impédance de sortie du dispositif semiconducteur et $C_o$ étant la capa-cité parasite de sortie du boîtier.

La figure 7 présente des courbes comparatives d'isolement en fonction de la fréquence de plu-sieurs boîtiers pour semiconducteurs hyperfré-quences. Les fréquences comprises entre 2 et 18 GHz sont données en abscisses, tandis que l'isolement en décibels est donné en ordonnées.

La courbe A, en trait continu épais, représente la courbe isolement-fréquence d'un boîtier ouvert, c'est-à-dire tel qu'il est représenté sur la figure 1 mais sans métallisation 7. Les conditions d'isolement sont les meilleures pour un semiconducteur encapsulé, mais cette solution n'est pas possible dans bien des cas, en particulier pour tous les matériels militaires ou spatiaux qui doivent être impérativement protégés. La courbe B, en trait continu et fin, donne la caractéristique isolement-fréquence pour un boîtier perfectionné selon la demande de brevet citée enregistrée sous le N° 81 09 935. Cette courbe met en évidence la forme relativement monotone de l'isolement, en ce sens que la valeur d'isolement croît à peu près régulièrement entre 2 et 18 GHz, sans qu'il y ait, comme c'est le cas sur des boîtiers non perfectionnés, deux pics d'absorption presque totale à 10 et à 15 GHz. Ainsi, la courbe B montre qu'à 15 GHz l'isolement est de l'ordre de — 20db. Enfin, la courbe C, en pointillés, donne la valeur d'isolement d'un boîtier selon la présente invention. On voit qu'à 15 GHz il y a un gain de l'ordre de 15 db dans l'isolement et que celui-ci atteint — 30 db. A 18 GHz, le gain dans l'isolement est encore de l'ordre de — 20 db.

La métallisation qui permet d'obtenir la réflexion de l'énergie incidente par mise à la masse du boîtier est par exemple une métallisation de type or-germanium, déposée par pulvérisation cathodique sur une épaisseur de 0,1 μm, suivie d'un enrichissement en or de quelques microns d'épaisseur, ou de tout autre métal conducteur moins dispendieux que l'or. Il est également possible dans le cadre de l'invention, de ne métalliser que le cadre 2, et d'utiliser le couvercle 3 recouvert d'une couche métallique résistive révélée dans le brevet cité. Il est enfin possible, dans le cadre de l'invention, de ne métalliser qu'une ou de préférence deux bandes, sur les flancs du cadre céramique 2. Ces bandes métallisées sont bien entendu chacune le plus près possible des connexions externes 5 et 6, tout en maintenant une réserve 12 pour ne pas les mettre à la masse : le résultat est d'autant plus efficace que les condensateurs parasites sont mis à la masse le plus près possible des connexions externes 5 et 6. Dans ce cas de métallisation par bandes, il suffit de métalliser, sur la figure 4, les deux seuls flancs du cadre 2 qui portent les connexions externes 5 et 6. Bien entendu, ces bandes doivent être également en contact avec la métallisation de fermeture 7 + 8 et avec l'embase 1 à la masse.

La description qui a été faite de l'invention, s'appuyant sur le cas de dispositifs à trois électrodes, et sur le cas de boîtiers rectangulaires, s'applique tout aussi bien à n'importe quel autre type de dispositifs semiconducteurs hyperfréquences, quel que soit le nombre des électrodes d'accès, quelle que soit la forme du boîtier, le fondement de l'invention étant de prélever l'énergie dérivée par l'intermédiaire d'un condensateur parasite au plus près de l'endroit où cette énergie est dérivée et de la réfléchir par une mise à la masse de l'ensemble du boîtier. De façon plus générale, l'invention est précisée par les revendications suivantes.

**Revendications**

1. Boîtier d'encapsulation pour semiconducteur de puissance fonctionnant dans une gamme de fréquence de 2 à 20 GHz, comprenant une embase (1) métallique, un cadre (2) en matériau isolant à travers lequel passent au moins deux connexions externes d'accès au semiconducteur encapsulé, dites d'entrée (5) et de sortie (6), et un couvercle (3) en matériau isolant, fixé sur le cadre (2) par soudure au moyen d'une métallisation (7) déposée sur la face libre du cadre (2) et d'une métallisation (8) déposée sur la face du couvercle (3) en regard du cadre (2), la face extérieure du cadre (2) et du couvercle (3) étant de plus recouverte par une métallisation conductrice (11), ménageant des réserves (12) autour des connexions d'entrées-sorties (5-6), ce boîtier étant caractérisé en ce que l'isolement entre les connexions d'entrée et de sortie (5-6) est amélioré par la mise en contact électrique de la métallisation conductrice (11) extérieure, elle-même en contact avec les métallisations (7, 8) de soudure, avec l'embase métallique qui est à la masse électrique du circuit comprenant le semiconducteur encapsulé dans ce boîtier.

2. Boîtier d'encapsulation selon la revendication 1, caractérisé en ce que le couvercle (3) est métallisé sur sa face extérieure et sur ses faces latérales.

3. Boîtier d'encapsulation selon la revendication 1, caractérisé en ce que le cadre (2) est également métallisé sur ses parois intérieures, avec réserves des connexions d'entrée-sorties (5, 6).

4. Boîtier d'encapsulation selon la revendication 1, caractérisé en ce que la métallisation (11) du cadre (2) est limitée à au moins une bande métallique qui réunit les métallisations (7, 8) de soudure du couvercle (3) à l'embase métallique (1).

5. Boîtier d'encapsulation selon la revendication 1, caractérisé en ce que la métallisation (11) du cadre (2) et du couvercle (3) est constituée par un dépôt d'or-germanium, sur 0,1 micron d'épaisseur, et par un dépôt d'or d'enrichissement.

**Claims**

1. Package of a power semiconductor operating in a frequency range from 2 to 20 GHz, comprising a metallic base (1), a frame (2) of insulating material wherethrough at least two external connections to the enclosed conductor extend, referred to as input (5) and output (6) connections, and a cover (3) of insulating material fixed on the frame (2) by soldering by means of a metallization (7) deposited on the free face of the frame (2) and a metallization (8) deposited on the face of the cover (3) facing the frame (2), said external face of the frame (2) and of the cover (3) being additionally coated with a conductive metallization (11), arranging recessed portions (12) about the input-ouptut connections (5-6), this package being characterized in that the insulation between the input and output connections (5-6) is improved by the fact that the external conductive metallization (11) which in turn contacts the soldering metallizations (7, 8) is electrically contacted with the metallic base which is connected to the electrical ground of the circuit comprising the semiconductor enclosed in this package.

2. Package according to claim 1, characterized in that the cover (3) is metallized on its outer face and on its lateral faces.

3. Package according to claim 1, characterized in that the cover (2) is likewise metallized on its internal walls, recesses being provided about the input-output connections (5, 6).

4. Package according to claim 1, characterized in that the metallization (11) of the frame (2) is limited to at least one metallic strip connecting the soldering metallizations (7, 8) of the cover (3) with the metallic base (1).

5. Package according to claim 1, characterized in that the metallization (11) of the frame (2) and of the cover (3) is constituted of a gold-germanium of 0.1 micron thickness and of an enrichment gold deposit.

**Patentansprüche**

1. Kapselgehäuse für Leistungshalbleiter, die in einem Frequenzbereich von 2 bis 20 GHz arbeiten, mit einem metallischen Sockel (1), einem Rahmen (2) aus Isoliermaterial, durch welchen hindurch sich wenigstens zwei externe Anschlüsse für den Zugang zu dem gekapselten Halbleiter erstrecken, die als Eingangsverbindung (5) und Ausgangsverbindung (6) bezeichnet werden, und mit einem Deckel (3) aus Isoliermaterial, welcher an dem Rahmen (2) durch Lötung befestigt ist mittels einer auf der freien Fläche des Rahmens (2) aufgebrachten Metallisierung (7) und einer Metallisierung (8), welche auf der Fläche des Deckels (3) aufgebracht ist, die dem Rahmen (2) zugewandt ist, wobei die Außenflächen des Rahmens (2) und des Deckels (3) ferner mit einer leitenden Metallisierung (11) beschichtet sind, die um die Ein- und Ausgangsverbindungen (5-6) herum Aussparungen (12) aufweist, wobei dieses Gehäuse dadurch gekennzeichnet ist, daß die Isolierung zwischen den Eingangs- und Ausgangsverbindungen (5-6) dadurch verbessert ist, daß die äußere leitende Metallisierung (11), welche in Berührung mit den Lötmetallisierungen (7, 8) ist, in elektrischen Kontakt mit dem metallischen Sockel gebracht ist, der auf der elektrischen Masse der Schaltung liegt, welche den in diesem Gehäuse eingekapselten Halbleiter umfaßt.

2. Kapselgehäuse nach Anspruch 1, dadurch gekennzeichnet, daß der Deckel (3) auf seiner Außenfläche und auf seinen Seitenflächen metallisiert ist.

3. Kapselgehäuse nach Anspruch 1, dadurch gekennzeichnet, daß der Rahmen (2) auch an seinen Innenwänden metallisiert ist, mit Aussparungen um die Eingangs-Ausgangsverbindungen (5, 6).

4. Kapselgehäuse nach Anspruch 1, dadurch gekennzeichnet, daß die Metallisierung (11) des Rahmens (2) auf wenigstens einem Metallstreifen begrenzt ist, welcher die Lötmetallisierungen (7, 8) des Deckels (3) mit dem metallischen Sockel (1) verbindet.

5. Kapselgehäuse nach Anspruch 1, dadurch gekennzeichnet, daß die Metallisierung (11) des Rahmens (2) und des Deckels (3) durch eine Gold-Germanium-Ablagerung der Dick 0,1 Mikron und durch eine anreichernde Goldablagerung gebildet ist.

# FIG.1

# FIG. 2

$$E_i \quad\quad E_o$$

$$7+8$$

# FIG. 3

$$E_i \quad\quad E_o$$

$$R$$

# FIG.4

# FIG. 5

# FIG. 6

# FIG. 7